Europäisches Patentamt

European Patent Office

Office européen des brevets

(19)

(11) Numéro de publication: **0 036 826**
**B1**

(12) **FASCICULE DE BREVET EUROPEEN**

(45) Date de publication du fascicule du brevet:
03.07.85

(51) Int. Cl.⁴: **H 05 K 13/04**

(21) Numéro de dépôt: 81400465.1

(22) Date de dépôt: 24.03.81

(54) Machine automatique de câblage de circuits électroniques hybrides.

(30) Priorité: 25.03.80 FR 8006789

(43) Date de publication de la demande:
30.09.81 Bulletin 81/39

(45) Mention de la délivrance du brevet:
03.07.85 Bulletin 85/27

(84) Etats contractants désignés:
AT BE CH DE FR GB IT LI LU NL SE

(56) Documents cités:
FR - A - 2 379 909
US - A - 3 731 867
US - A - 4 116 348

(73) Titulaire: **EUROSOFT ROBOTIQUE, Route de Cholet,
F-85260 Rocheservière (FR)**

(72) Inventeur: **Mouton, Bernard, La Vallée Bouffere,
F-85600 Montaigu (FR)**
Inventeur: **Gardet, Patrick, La Malveille,
F-85170 St-Denis la Chevasse (FR)**
Inventeur: **Chatalgnier, Gabriel, Lotissement Les Ajoncs,
F-85620 Rocheserviere (FR)**

(74) Mandataire: **Phélip, Bruno et al, c/o Cabinet Harlé &
Phélip 21, rue de la Rochefoucauld, F-75009 Paris (FR)**

ACTORUM AG

## Description

La présente invention concerne la réalisation des câblages des circuits électroniques, et plus précisément la phase consistant à reporter les composants sur un substrat.

Dans ce domaine, on connaît déjà la technique de réalisation des circuits soit par sérigraphie, soit à l'aide d'un dépôt sous vide de conducteurs, de résistances, de selfs ou de condensateurs sur un support ou substrat généralement en alumine. Il est ensuite procédé au report sur ce substrat, de micro-composants selon un positionnement rigoureux. La réalisation des circuits hybrides comportant des composants de technologies différentes, tels que des composants actifs et passifs, ou des composants de faible ou de forte puissance, implique que le report de ceux-ci sur le substrat soit effectué automatiquement. Le développement de ces types de circuits a ainsi provoqué l'apparition de deux types de machines à reporter les mini- et micro-composants sur des substrats. Un premier type de ces machines correspond à des appareils d'aide à la manipulation des composants pour lesquels l'opérateur assure lui-même le positionnement précis du composant au moment de sa prise dans le magasin et au moment de sa pose sur le substrat, ce positionnement s'effectuant généralement à l'aide d'un dispositif de visée optique. Un second type de ces machines correspond à des machines automatiques conçues pour le câblage de grandes séries à des cadences élevées avec un nombre limité de types de composants. Compte tenu de leur coût généralement élevé, ces machines ne peuvent convenir que pour des fabrications de grandes séries et limitées à certains types seulement de circuits électroniques.

Par ailleurs le brevet US-A 4 116 348 décrit un dispositif de câblage comportant une machine de câblage miniature associée à un dispositif de commande, ladite machine de câblage miniature comportant un robot miniature pourvu d'une tête de préhension munie d'une buse d'aspiration. Cette machine de câblage comprend en outre un dispositif de contrôle de buse destiné à vérifier l'état convenable de fonctionnement de la buse, tandis que le dispositif de commande comprend un pupitre de commande.

On peut également citer la demande FR-A-2 379 909 dans laquelle est décrit une machine automatique de câblage de circuits électroniques, comportant un ordinateur programmé pour contrôler et commander ladite machine de câblage.

La machine, suivant l'invention, destinée au câblage électronique par report de mini-composants sur substrats et plus particulièrement dans le domaine de la mini-électronique par le report de ces mini-composants sur un substrat de grande dimension tel qu'un circuit imprimé par exemple, permet la digitalisation du circuit à câbler, le traitement des informations de nomenclature et de conception assistée par ordinateur, la préparation du chargement des magasins de composants, l'orientation et le report de ces composants sur le circuit avec apport de flux décapant pour assurer leur maintien avant soudure sur le substrat ou le report d'empreintes de pâte à souder sur le circuit avant la pose des composants.

Plus précisément, l'invention concerne une machine automatique de câblage de circuits électroniques hybrides par report de composants sur des substrats comprenant un dispositif de commande comportant un pupitre de commande, au moins une machine de câblage miniature, la machine de câblage miniature comprenant un robot miniature ayant une tête de préhension munie d'une buse d'aspiration possédant un degré de liberté en rotation autour de son axe longitudinal, ladite machine de câblage comprenant en outre un dispositif de contrôle de buse destiné à vérifier l'état convenable de fonctionnement de la buse d'aspiration, caractérisée en ce que la buse d'aspiration est interchangeable sur la tête, que la tête de préhension est destinée à se déplacer, selon trois degrés de liberté en translation au-dessus de plusieurs postes de travail, tels qu'un poste de chargement et de déchargement de circuits à câbler, un poste de recentrage de composant, un poste de fluxage, un poste de câblage et un poste de rangement de buse d'aspiration et en ce que ledit dispositif de commande comprend en outre un mini ordinateur destiné à commander les différents mouvements du robot miniature et le dispositif de contrôle de buse.

Dans un mode de réalisation avantageux, la tête de préhension est placée sur un support monté lui-même sur un premier chariot de manière que ce support puisse coulisser en étant normalement rappelé vers une première position déterminée, et le dispositif de contrôle de buse comporte un premier détecteur destiné à transmettre une indication du fait que ce support est dans sa première position prédéterminée ou non. Il est en outre avantageux que le dispositif de contrôle de buse comporte un second détecteur destiné à transmettre une indication du fait que le premier chariot est lui-même dans une seconde position déterminée.

En outre, il est avantageux que le dispositif de commande règle le déplacement de la tête de préhension afin que la buse vienne au contact dudit second détecteur, le premier détecteur donnant une indication du fait que le support quitte sa première position déterminée. Le dispositif de commande peut alors déterminer le déplacement du chariot entre la seconde position déterminée indiquée par le second détecteur et la position qu'il occupe au moment où le premier détecteur donne une indication du fait que le support quitte sa position déterminée. Le dispositif de commande peut alors avantageusement comparer le déplacement du chariot à un déplacement de référence et déterminer l'écart entre les deux déplacements puis, selon que cet écart est supérieur ou inférieur a un seuil déterminé, il indique une anomalie ou non. En outre, il est avantageux que le dispositif de commande détermine le sens de cet écart ayant provoqué l'indication d'une anomalie afin qu'il indique que la buse est mal montée sur le porte-buse lorsque l'écart a un premier sens et que la buse est usée lorsque l'écart a le sens opposé.

En outre, il est avantageux que le porte-buse soit relié à un dispositif d'aspiration par une électrovanne, et que le dispositif de contrôle de buse comporte un manocontact à dépression placé sur le circuit d'aspiration entre le porte-buse et l'électrovanne et destiné à détecter une fuite d'air au niveau de la buse et à indiquer ainsi la présence ou l'absence d'un composant à l'extrémité de la buse.

Dans un mode de réalisation avantageux, le porte-buse de la tête de préhension est monté sur l'arbre d'un moteur rotatif pas à pas tournant autour d'un axe sensiblement vertical et destiné à régler l'orientation du composant; la machine comporte avantageusement, en plus du premier chariot qui porte le support de la tête de préhension et qui est mobile suivant l'axe sensiblement vertical, un second chariot mobile suivant une première direction sensiblement horizontale, portant le premier chariot et lui-même monté sur un troisième chariot mobile suivant une seconde direction horizontale sensiblement perpendiculaire à la première. Les mouvements de translation des chariots sont assurés par des moteurs pas à pas coopérant avec des courroies crantées assurant une transmission sans glissement.

La machine comporte avantageusement une table destinée à porter au moins deux substrats et mobile en translation dans un plan sensiblement horizontal, afin que la table puisse présenter un substrat au robot tout en permettant le chargement et le déchargement d'un autre substrat.

Selon une autre caractéristique avantageuse, la machine comporte des plateaux portant des réglettes de support de composants, adaptées aux types et dimensions des composants qu'elles contiennent; des vibreurs agissent sur les réglettes afin qu'ils provoquent l'avance des composants sur celles-ci.

Il est aussi avantageux que la machine comporte un poste de rangement de buses ayant plusieurs logements et comportant des capteurs en nombre au moins égal au nombre de logements afin qu'ils indiquent la présence ou l'absence d'une buse à chacun des logements.

La machine comporte en outre avantageusement un appareil de visée optique à réticule dont le déplacement est commandé à l'aide d'un levier de commande; la manipulation du levier de commande permet le positionnement du dispositif de visée et l'introduction de données correspondant à cette position dans le dispositif de commande.

Selon une architecture avantageuse, le miniordinateur comporte un processeur maître et des processeurs esclaves, ces derniers étant destinés à commander les déplacements dans les différentes directions, avec accélération et décélération des moteurs pas à pas.

Ainsi, la tête de préhension peut se déplacer au-dessus de la table qui porte la zone de pose et de chaque côté de laquelle se trouvent des zones de préhension de composants. Chaque zone de préhension a un plateau ayant un certain nombre de réglettes et des vibreurs supportent les plateaux afin que les composants descendent le long des réglettes à proximité de la zone de pose où une buse d'aspiration les prélève au moment opportun. Un poste de recentrage des composants est avantageusement placé à proximité de la zone de pose, et des zones de fluxage, où des composants peuvent être trempés dans un flux décapant avant leur pose, sont ménagées à proximité, le flux assurant, en plus de son pouvoir décapant, un collage du composant en place sur le circuit. Selon une autre caractéristique avantageuse, la machine met en œuvre un système de point d'origine flottant utilisant, pour chaque axe de translation horizontale, deux registres contenant à tout instant la coordonnée du point par rapport à l'origine de la machine et la coordonnée de ce même point par rapport à une autre origine prise sur le circuit à câbler, les deux registres étant incrémentés ou décrémentés simultanément pendant les mouvements de la tête de préhension.

L'utilisation conjuguée du premier détecteur et du programme permet la vérification rapide de la précision en différents points de la machine, en direction verticale, et l'utilisation conjuguée du dispositif de visée optique et du programme permet un contrôle rapide et précis en différents points de la machine, suivant des axes horizontaux, et en particulier dans les zones de préhension, de pose, de recentrage et de rangement de buses.

D'autres caractéristiques et avantages de l'invention ressortiront mieux de la description qui va suivre, faite en référence aux dessins annexés sur lesquels:

– la figure 1 est une perspective de l'ensemble d'une machine selon l'invention;

– la figure 2 est une élévation de la tête de préhension et de son support, dans la machine de la figure 1;

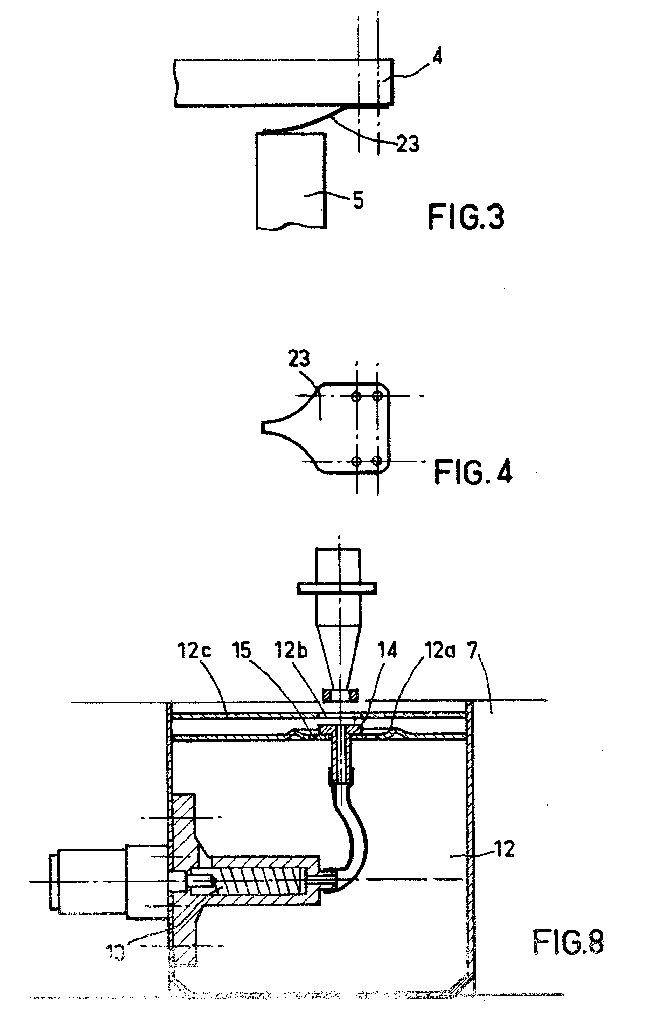

– les figures 3 et 4 représentent en élévation et en plan respectivement un détail d'un dispositif permettant l'application aux composants d'une force programmée d'appui;

– les figures 5, 6 et 7 sont respectivement une élévation, une vue de bout et une vue partielle en plan d'un poste de rangement de buses d'aspiration;

– la figure 8 est une coupe schématique d'un mode de réalisation de poste de fluxage;

– la figure 9 est une élévation en coupe partielle d'une variante de porte-buse et de tête de préhension associée;

– la figure 10 est un schéma agrandi d'une partie de l'appareil de la figure 9;

– les figures 11 et 12 sont respectivement une coupe par un plan vertical et une vue en plan d'un second mode de réalisation de poste de fluxage; et

– les figures 13 et 14 sont respectivement une vue en plan et une vue de bout d'une partie des plateaux de support de réglettes de la machine de la figure 1.

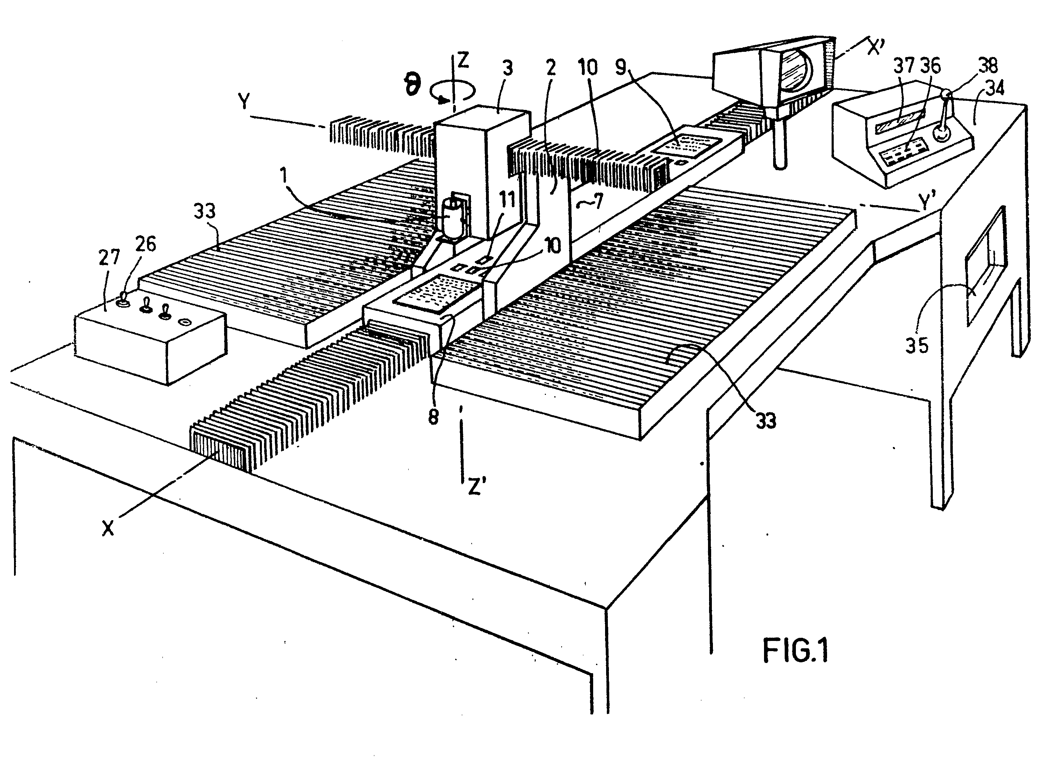

Telle que représentée sur la figure 1, la machine se présente selon un ensemble groupant une machine de mini-câblage et de digitalisation, et un pupitre électronique de commande, le mini-ordinateur qui lui est associé n'étant pas représenté. La machine de mini-câblage est constituée d'un mini-robot dont la tête de préhension 1 peut se déplacer selon quatre degrés de liberté:

— dans un plan horizontal selon l'axe XX′ correspondant à l'axe longitudinal de la machine,

— dans un plan horizontal selon l'axe YY′ perpendiculaire à l'axe XX′,

— dans un plan vertical selon l'axe ZZ′,

— en rotation θ autour de l'axe ZZ′.

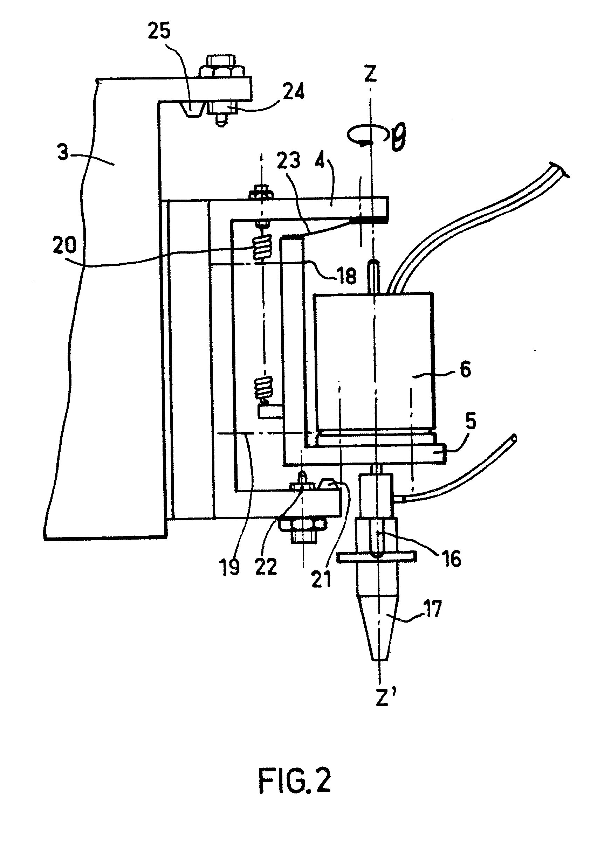

La machine comporte à cet effet un chariot 2 monté sur deux rails situés de part et d'autre du plan de câblage, permettant la translation horizontale selon XX′; sur ce chariot est fixé un chemin de roulement horizontal constitué de rails disposés perpendiculairement à XX′, permettant une translation selon YY′ d'un second chariot 3, sur lequel est également monté coulissant un troisième chariot 4 (figure 2) assurant une translation verticale selon ZZ′ du support 5 de la tête de préhension 1. L'entraînement en rotation de ladite tête selon un mouvement θ autour de l'axe ZZ′ est assuré par un moteur électrique pas à pas 6 monté sur le support 5. De même, les différents mouvements de translation selon les axes XX′, YY′ et ZZ′ sont assurés par des moteurs électriques pas à pas associés à des courroies crantées assurant une transmission sans glissement. La tête de préhension peut ainsi se déplacer au-dessus d'une table 7 dont la face supérieure constituant la zone de pose possède deux emplacements 8 et 9 pouvant recevoir simultanément deux circuits imprimés à câbler. Cette table est mobile en translation selon l'axe XX′, sa translation étant assurée par commande manuelle; son déplacement permet le chargement et le déchargement d'un circuit pendant que l'autre est en position de câblage; une sécurité électro-mécanique interdit tout mouvement de la table pendant l'opération de câblage en cours. A proximité de chaque emplacement 8 ou 9 sur la table 7 et dans le même plan que le circuit à câbler est prévue une zone de recentrage des composants. Celle-ci se compose d'une plaque 10, portant des perforations rectangulaires de dimensions différentes adaptées aux différents types de composants à utiliser; les dimensions longueur et largeur de chacune de ces perforations sont légèrement supérieures à celles du composant correspondant. Selon un procédé connu, les mouvements selon X et Y imprimés à la tête de préhension provoquent un mouvement oscillant amorti dans les deux axes, entraînant, par mises en appui successives du composant sur les bordures de la perforation correspondante, un glissement du composant par rapport à l'organe de préhension en début d'oscillation, puis à la fin de celle-ci le composant se trouve centré par rapport à ladite perforation.

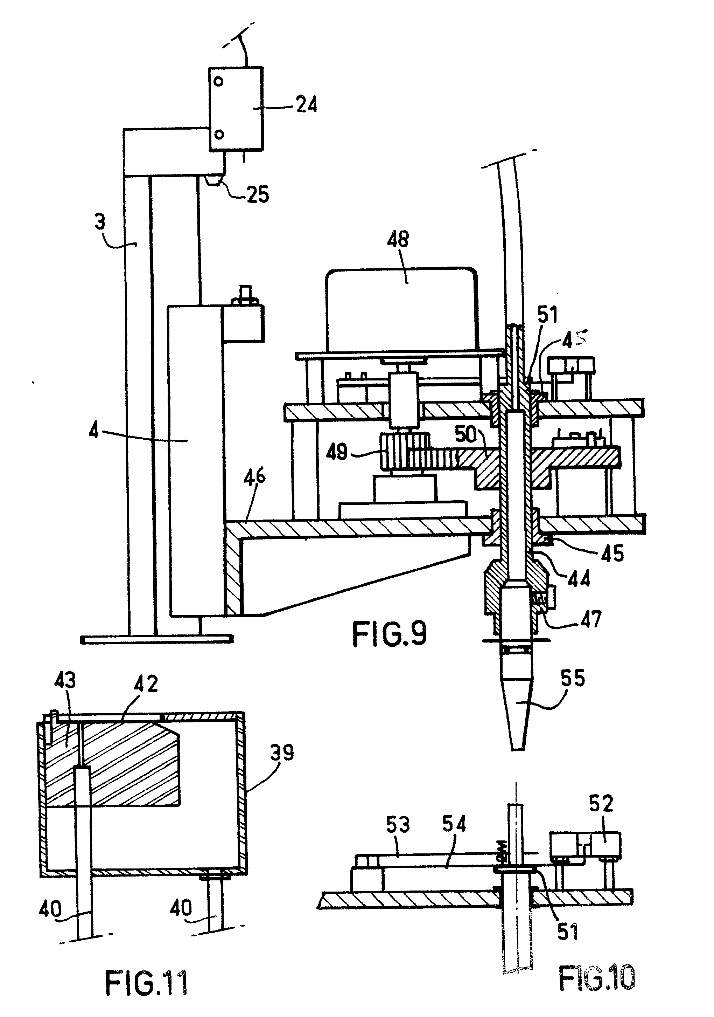

Sur la table 7 dans le plan du circuit à câbler et à proximité de la zone de recentrage, sont prévus en 11 deux postes de fluxage (figure 8) constitués chacun d'un petit réservoir 12 contenant un flux décapant et dans lequel aspire une pompe électrique 13 pour refouler ledit flux sur la face supérieure du réservoir, par une buse de diffusion de petit calibre 14 placée au centre d'une coupelle 12a, le débit du flux s'effectuant sous forme d'un mince filet limité à la surface de l'extrémité de la buse 14, le flux faisant retour au réservoir à travers une série de trous 15 prévus au fond de la coupelle. L'accès au point de trempage des composants est limité à un orifice 12b prévu dans une plaque 12c recouvrant le poste de fluxage et limitant l'évaporation du solvant contenu dans le flux.

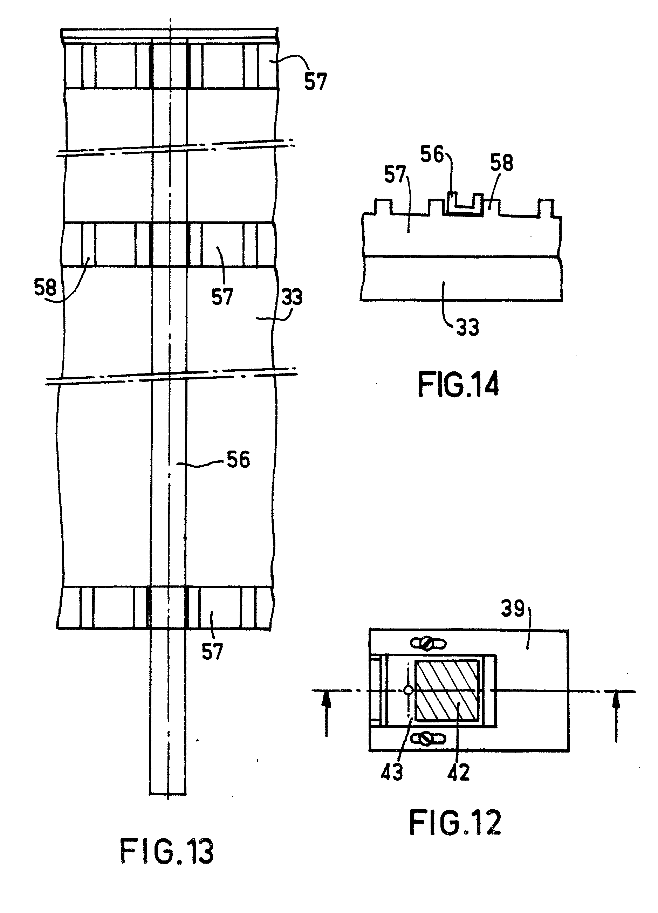

Les figures 11 et 12 représentent une variante de poste de fluxage. Le poste comporte un petit réservoir 39 ayant à sa partie supérieure une plate-forme 43 sur laquelle est posé un petit carré 42 de tissu synthétique, par exemple de «Tergal», maintenu toujours imprégné de flux décapant par une pompe électrique non représentée qui arrose en permanence le morceau de tissu. L'excédent de flux retombe dans le réservoir et est transmis par l'une des canalisations 40 à la pompe qui le refoule à nouveau par l'autre canalisation 40. Les composants sont posés sur le morceau de tissu humide, avant d'être placés sur le circuit, et ils reçoivent ainsi une mince pellicule de flux. Celui-ci, en plus de son pouvoir décapant, assure le collage des composants sur le circuit avant la soudure.

La tête de préhension comporte (figure 2) un ajutage 16 monté en bout d'arbre du moteur 6, sur lequel ajutage s'adapte une buse d'aspiration 17, le porte-buse ainsi réalisé étant relié à une pompe à vide par l'intermédiaire d'une électrovanne et d'un tuyau souple; un manocontact à dépression situé sur le circuit d'aspiration entre le porte-buse et l'électro-vanne permet de détecter une fuite d'air au niveau de la buse et de vérifier de cette manière la présence d'un composant à l'extrémité de la buse.

Le support 5 en forme d'équerre sur lequel est montée la tête de préhension est relié au chariot 4 par une liaison élastique constituée de deux lames flexibles parallèles 18 et 19 implantées dans la structure en forme de U du chariot, lesquelles lames constituent ainsi un parallélogramme déformable. Le poids propre de l'ensemble du support 5, du moteur 6 et du dispositif porte-buse est compensé par un ressort de traction 20 d'action verticale reliant le support 5 au chariot 4. La figure 2 représente le support 5 en position intermédiaire. En position correspondant à la position de la tête de préhension au cours de ses déplacements, le support 5 repose sur une butée mécanique 21 à proximité de laquelle se situe un micro-contact réglable 22 destiné à détecter l'instant où le support 5 cesse d'être en contact avec ladite butée mécanique 21, instant correspondant à celui où la buse entre en contact avec le composant. Un ressort 23 dont la force croît de façon non linéaire, par exemple d'une façon exponentielle ou quadratique avec l'allongement, est intercalé entre l'extrémité supérieure du support 5 et la face interne du U constituant la structure du chariot 4. Ce ressort permet d'exercer sur le composant une force d'appui programmée, notamment dans le cas de la dépose de ce composant sur l'élément de pâte à souder préalablement déposé sur le circuit à l'emplacement désiré pour le composant.

Les figures 9 et 10 représentent une variante de la tête de préhension. La tête comporte un axe télescopique vertical 44 monté dans deux paliers lisses 45 fixés sur un support 46 solidaire du chariot 4 mobile en direction verticale et l'axe est muni, à son extrémité inférieure, d'un porte-buse 47 qui a un alésage dans lequel s'emboîte une buse 55 d'aspiration. L'axe est entraîné en rotation par un moteur pas à pas 48, par l'intermédiaire d'un couple de pignons droits 49, 50. L'équipage mobile constitué par l'axe, le porte-buse et un pignon droit, muni d'une butée mécanique 51 et d'un contact opto-électronique 52 de précision, peut subir de petits déplacements verticaux par rapport au chariot 4 et permet ainsi la détection du moment où la buse 55 entre en contact avec un composant, par exemple.

Le dispositif décrit, comme représenté sur la figure 10, comporte un ressort à deux lames 53, 54 dont la force croît de manière non linéaire avec l'allongement, si bien que les variations de la force appliquée à chaque composant peuvent être programmées commodément. Plus précisément, l'ensemble formé par les deux lames exerce sur l'axe 44, par l'intermédiaire de la butée 51, une force verticale qui croît de manière non linéaire avec l'enfoncement dans le support. L'une des lames est reliée au capteur opto-électronique de précision 52 si bien que tout mouvement relatif de l'axe et du support, représentatif du contact de la buse avec un composant, est immédiatement détecté.

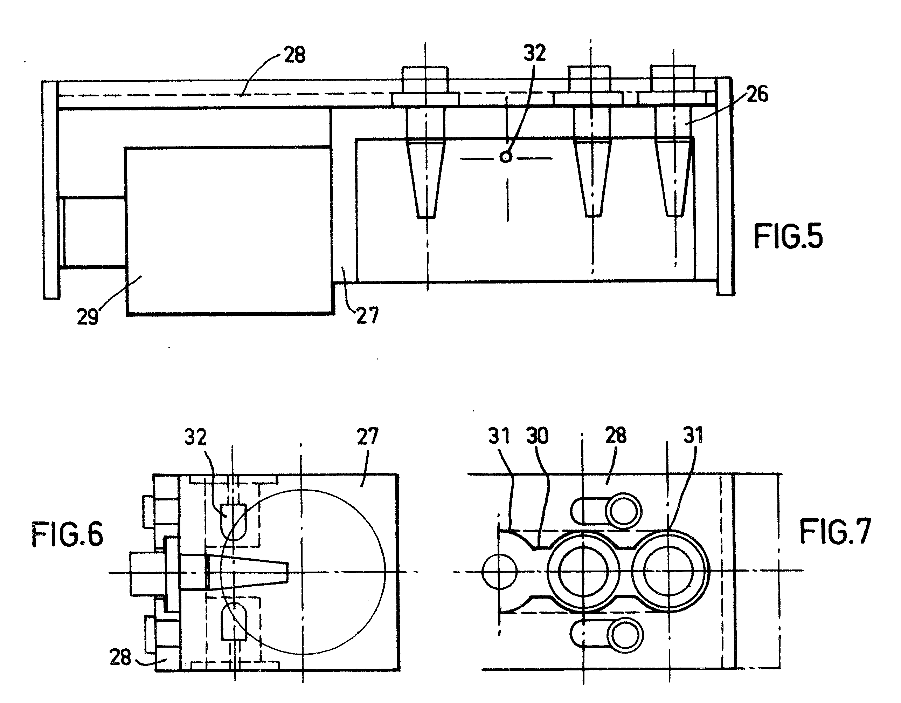

Dans son mouvement ascensionnel selon l'axe vertical ZZ', le chariot 4 vient en appui sur un micro-contact électrique 24 indiquant une référence d'altitude haute, lequel contact est assorti d'une butée mécanique 25. La tête de préhension est conçue pour utiliser plusieurs buses de diamètres d'ouverture différents, adaptées aux composants à manipuler. Tel que représenté en figures 5, 6 et 7, chacune d'elles possède un logement 26 dans un poste de rangement 27 situé à proximité des zones d'intervention de la tête de préhension. L'opération de changement de buse commence par un positionnement par les mouvements selon XX' et YY' de la tête de préhension au-dessus du logement libre. La descente de la buse dans son logement est obtenue par translation du chariot 4 selon ZZ'. Cette opération est suivie d'un verrouillage des buses dans leur logement par translation horizontale d'une plaque de tête 28 sous l'action d'un électro-aimant 29, les parties resserrées 30 de la découpe de ladite plaque situées entre chaque alésage 31 permettant l'introduction des buses venant dans ce déplacement brider l'épaisseur de la partie épaulée de chaque buse. La remontée de la tête de préhension selon ZZ' désaccouple la buse de l'ajutage ou de l'alésage du porte-buse, la buse restant dans son logement. La tête est alors dirigée au-dessus de la nouvelle buse à utiliser. La descente de la tête provoque l'emboîtage de l'ajutage ou de l'alésage sur cette buse; après déverrouillage de l'ensemble des buses, la tête de préhension peut remonter équipée de la nouvelle buse. Chaque logement de buse du poste de rangement est équipé d'un capteur opto-électronique 32 permettant de vérifier si l'échange de buse s'est bien opéré et aussi de connaître à tout instant quelle est la buse qui est montée sur la tête de préhension.

De part et d'autre de la table 7 et bordant la zone de translation selon XX' du chariot 2 sont disposées deux zones de préhension constituées chacune de deux plateaux 33 portés par des vibreurs linéaires, lesquels plateaux comportent chacun un certain nombre de réglettes adaptées au type et à la dimension des composants qu'elles contiennent. Sous l'action des vibreurs, les composants sont acheminés vers l'extrémité la plus proche de la zone de câblage, d'où ils seront pris par la buse d'aspiration. Le chargement des composants s'effectue en deux temps correspondant successivement au chargement des plateaux 33 en réglettes selon les indications fournies par le listage de chargement et au chargement des plateaux munis de leurs réglettes sur la machine à l'emplacement indiqué par le listage.

Les figures 13 et 14 représentent un mode de réalisation particulièrement avantageux de montage des réglettes qui portent les composants. Plus précisément, les réglettes 56 sont maintenues sur les plateaux 33 par coincement obtenu par déformation élastique des réglettes elles-mêmes. Chaque plateau a trois barrettes parallèles 57 munies de dents 58. Les dents des trois barrettes ne sont pas alignées car celles de la barrette médiane sont légèrement décalées par rapport aux dents des deux autres barrettes. De cette manière, l'introduction d'une réglette entre les dents des trois barrettes nécessite la courbure de la réglette. Cette déformation élastique provoque l'appui de la réglette contre une dent de chacune des trois barrettes, d'un côté de la réglette pour la barrette médiane et de l'autre côté pour les deux barrettes d'extrémité. La réglette est alors immobilisée par friction contre les dents.

La machine est équipée d'un pupitre de commande 34 renfermant tous les organes électroniques de commande, ainsi qu'un lecteur de bande perforée 35, de cassette, de disquette ou de tout autre support d'information, un clavier à touches 36 et un afficheur 37. Les informations nécessaires au fonctionnement de la machine sont lues sur la bande perforée par le lecteur: l'exploitation de ces informations ainsi que la commande et le contrôle de tous les mouvements sont assurés par un système multiprocesseur à base de microprocesseurs. Un processeur maître traite les informations du lecteur pour obtenir des informations de mouvements élémentaires qui sont alors envoyées à des processeurs esclaves, lesquels prennent en charge la commande des différents mouvements élémentaires et avertissent le processeur maître lorsque ces mouvements sont terminés. Une telle structure permet d'assurer simultanément différents mouvements dans les meilleures conditions de vitesse; en particulier, elle permet de contrôler simultanément sur les trois axes XX', YY' et ZZ' les rampes d'accélération et de décélération des moteurs pas à pas assurant les mouvements de translation de la tête de préhension selon ces axes. Chacun de ces moteurs pas à pas est commandé en mode «une phase – deux phases» aux basses vitesses, de manière à lui assurer un incrément angulaire d'un demi-pas moteur et en mode «deux phases» aux vitesses élevées. Afin de diminuer au maximum le temps d'établissement du courant dans les phases, les moteurs sont alimentés par des sources de courant à découpage qui assurent en même temps une consommation d'énergie et une dissipation calorifique réduites.

L'opération de câblage proprement dite est précédée des opérations suivantes. A partir des informations de conception assistée par ordinateur, introduites par le lecteur de bande perforée ou par tout autre lecteur et des informations de nomenclature sur cartes perforées, l'ordinateur effectue les contrôles nécessaires pour déterminer les éléments manquants ou erronés. Après entrée des modifications éventuelles par l'opérateur, l'ordinateur fait une optimisation du chargement des réglettes des composants et édite le listage du chargement correspondant. Enfin, l'ordinateur prépare le programme de câblage qui alimentera la machine de mini-câblage. Ce programme peut être directement transmis à la machine par l'intermédiaire d'une liaison de type série ou bien enregistré sur ruban perforé, cassette, disquette ou tout autre support informatique, pour être relu par le lecteur de la machine de mini-câblage.

La machine peut également fonctionner en digitaliseur. Dans ce cas, la machine est reliée au calculateur et le chariot d'axe Y est équipé d'un appareil de visée optique à réticule, par exemple une caméra vidéo. L'opérateur commande le déplacement du viseur à l'aide d'un levier de commande type «manche à balai» 38 de manière à amener son centre en coïncidence avec le centre de la surface où doit être posé le composant. Puis par l'intermédiaire du clavier de l'ordinateur, l'opérateur commande la lecture et l'enregistrement des coordonnées X et Y du point visé. Si les informations de nomenclature ne sont pas présentes sur l'ordinateur, l'opérateur peut les rentrer sur le même clavier, à la suite des coordonnées, avant de passer au composant suivant. Lorsque la digitalisation est terminée, le listage de chargement des réglettes et le programme de câblage s'obtiennent d'une façon identique à celle précédemment décrite.

Après ces différentes opérations, il est procédé à l'enregistrement du point d'origine. Pour ce faire, l'opérateur amène, à l'aide du «manche à balai», 38, le centre du viseur optique en coïncidence avec un point caractéristique du circuit à câbler et dont les coordonnées X1 et Y1 par rapport à l'origine sur le circuit sont connues. Si les coordonnées X0 et Y0 de la tête de préhension à cet instant par rapport à l'origine sur la machine sont différentes de X1 et Y1, l'opérateur rentre les valeurs X1 et Y1 au clavier de la machine, qui prend ces nouvelles valeurs comme coordonnées du point caractéristique par rapport à une nouvelle origine sur la machine. Toute les coordonnées des points de câblage du circuit seront déterminées par rapport à la nouvelle origine. Par contre, c'est toujours l'ancienne origine qui est utilisée pour les coordonnées des points de préhension, des points de recentrage, des points de fluxage, des points de rangement des buses et des butées fin de course.

L'ensemble de ces opérations effectuées, il est alors procédé à l'exécution du câblage. L'opérateur enlève le dispositif de visée optique et lance le programme par la touche «câblage automatique». Un premier contrôle s'effectue pour vérifier si la table est en position de câblage, puis le verrouillage électrique est actionné pour lui interdire tout mouvement. La première opération commandée est un changement de buse. Si la buse demandée n'est pas celle qui est absente dans la zone de rangement, la tête se déplace au-dessus du logement vide pour y déposer sa buse, puis prend la buse demandée dans un autre logement. Le chariot 4 remonte jusqu'à la butée haute, puis la tête vient au-dessus d'un point servant de référence d'altitude. La tête descend alors lentement et parcourt la distance Z1 jusqu'à ce que le microcontact indique que la buse a atteint la référence d'altitude. Si l'écart entre Z1 et la valeur théorique Z0 est trop grand, une anomalie est signalée, pour indiquer suivant le signe de l'écart que la buse est trop courte, c'est-à-dire usée, ou trop longue, c'est-à-dire mal emboîtée sur le porte-buse. Sinon, la position atteinte est enregistrée comme altitude de référence pour tous les mouvements de montée et descente qui seront effectués avec cette buse, et la tête remonte en position haute.

Le programme passe alors à la deuxième opération qui correspond à un report de composant.

La tête se dirige vers l'extrémité de la réglette où sera pris le composant, pendant que les vibreurs sont actionnés. Lorsque la tête arrive audessus du composant, les vibreurs sont arrêtés, et l'aspiration est commandée. La tête descend à grande vitesse jusqu'à une altitude légèrement supérieure à celle du composant à prendre, puis lentement jusqu'au contact avec le composant. Le composant est aspiré, et la tête remonte à une altitude légèrement supérieure à celle du composant présent à l'extrémité de la buse, plus la hauteur du plus haut composant déjà posé.

Si le composant pris nécessite un recentrage, la tête se dirige vers le trou de centrage correspondant puis descend à grande vitesse jusqu'à l'altitude de centrage.

La tête remonte à la même altitude que précédemment et se dirige au-dessus de la zone de fluxage. Avant la descente de la tête, un contrôle d'absence de fuite d'air est effectué pour s'assurer que le composant est bien au bout de la buse. Si le composant est présent, la pompe à flux est arrêtée, et la tête descend à grande vitesse jusqu'à une altitude légèrement supérieure à celle du composant, puis lentement jusqu'au contact. Ensuite, la tête remonte, jusqu'à la même altitude que précédemment, et la pompe à flux est remise en marche puis la tête se dirige au-dessus du point de pose. Pendant ce déplacement, la rotation θ de la buse donne au composant son orientation définitive.

Un second contrôle de présence du composant est effectué avant la descente de la tête.

Si le composant est toujours présent, la tête descend à grande vitesse jusqu'à une altitude légèrement supérieure à celle du composant, puis lentement jusqu'au contact, et encore de quelques pas pour exercer sur le composant la pression programmée. (Pendant ces quelques pas, le mouvement Z applique sur le composant une force programmée qui croît de manière non linéaire en fonction du déplacement). L'aspiration est alors coupée et remplacée par une légère surpression. Au bout d'un temps de stabilisation de la pression, le mouvement Z remonte à une altitude légèrement supérieure à celle du plus haut composant déjà posé. L'aspiration est rétablie, et un dernier contrôle de présence de composant est effectué pour s'assurer cette fois que le composant a bien été posé, et l'opération suivante peut commencer.

Pour les composants ne nécessitant pas de recentrage, la tête passe directement du point de préhension au point de fluxage.

La tête s'arrête en fin de câblage en position haute au-dessus d'un point de dégagement programmé. La table est alors automatiquement déverrouillée pour permettre l'inversion entre la position de chargement et la position de câblage, le chargement d'un nouveau circuit pouvant s'effectuer pendant le câblage.

A titre d'exemple, la machine selon l'invention offre l'avantage de pouvoir manipuler jusqu'à cent composants de caractéristiques et de dimensions différentes, distribués en quatre plateaux de vingt cinq réglettes, une telle diversité de composants étant rendue possible grâce au système de changement automatique de buses, ainsi qu'au dispositif permettant d'exercer une force programmée sur les composants.

Le chargement des composants peut se faire en dehors de la machine sur des plateaux amovibles. La table de câblage à deux positions permet le chargement et le déchargement des substrats pendant le câblage. L'aire de câblage permet soit le câblage de substrats de grandes dimensions, soit le câblage d'ensembles de petits substrats.

La machine, objet de l'invention, peut être utilisée pour tous les travaux de câblage de circuits électroniques et plus particulièrement dans le domaine de la mini-électronique pour le report de mini-composants sur circuit imprimé ou tout autre substrat de grande dimension.

**Revendications**

1. Machine automatique de câblage de circuits électroniques hybrides par report de composants sur des substrats, comprenant un dispositif de commande comportant un pupitre de commande, au moins une machine de câblage miniature, la machine de câblage miniature comprenant un robot miniature ayant une tête de préhension munie d'une buse d'aspiration possédant un degré de liberté en rotation autour de son axe longitudinal, ladite machine de câblage comprenant en outre un dispositif de contrôle de buse destiné à vérifier l'état convenable de fonctionnement de la buse d'aspiration, caractérisée en ce que la buse d'aspiration est interchangeable sur la tête, que la tête de préhension est destinée à se déplacer, selon trois degrés de liberté en translation au-dessus de plusieurs postes de travail, tels qu'un poste de chargement et de déchargement de circuits à câbler, un poste de recentrage de composant, un poste de fluxage (11), un poste de câblage (8, 9) et un poste de rangement (27) de buse d'aspiration et en ce que ledit dispositif de commande comprend en outre un mini ordinateur destiné à commander les différents mouvements du robot miniature et le dispositif de contrôle de buse.

2. Machine selon la revendication 1, caractérisée en ce que la tête de préhension (1) est placée sur un support (5) monté sur un premier chariot (4) de manière qu'il puisse coulisser en étant normalement rappelé vers une première position déterminée, et le dispositif de contrôle de buse comporte un premier détecteur (22) destiné à transmettre une indication du fait que le support (5) est dans sa première position déterminée ou non.

3. Machine selon la revendication 2, caractérisée en ce que le dispositif de contrôle de buse comporte un second détecteur (24) destiné à transmettre une indication du fait que le premier chariot (4) est dans une seconde position déterminée.

4. Machine selon l'une des revendications 2 et 3, caractérisée en ce que l'un au moins des premier et second détecteurs (22, 24) est formé par un microcontact ou par un capteur opto-électronique.

5. Machine selon l'une des revendications 3 et 4, caractérisée en ce que le dispositif de commande règle le déplacement de la tête de préhension (1) afin que la buse vienne au contact dudit second détecteur (24) formant référence d'altitude, le premier détecteur (22) donnant une indication du fait que le support quitte sa première position déterminée.

6. Machine selon la revendication 5, caractérisée en ce que le dispositif de commande détermine le déplacement du chariot (4) entre la seconde position déterminée indiquée par le second détecteur (24) et la position qu'il occupe au moment où le premier détecteur (22) donne une indication du fait que le support (5) quitte sa position déterminée.

7. Machine selon la revendication 6, caractérisée en ce que le dispositif de commande compare le déplacement du chariot (4) à un déplacement de référence, et détermine l'écart entre les deux déplacements puis, selon que cet écart est supérieur ou inférieur à un seuil déterminé, il indique une anomalie ou non.

8. Machine selon la revendication 7, caractérisée en ce que le dispositif de commande détermine le sens de l'écart ayant provoqué l'indication d'une anomalie et indique soit que la buse est mal montée sur le porte-buse lorsque l'écart a un premier sens, soit que la buse est usée lorsque l'écart a le sens opposé.

9. Machine selon l'une quelconque des revendications précédentes, caractérisée en ce que le porte-buse est relié à un dispositif d'aspiration par une électrovanne, et le dispositif de contrôle de buse comporte un manocontact à dépression placé sur le circuit d'aspiration entre le porte-buse et l'électrovanne et destiné à détecter une fuite d'air au niveau de la buse (17) et à indiquer ainsi la présence ou l'absence d'un composant à l'extrémité de la buse.

10. Machine selon l'une quelconque des revendications 2 à 9, caractérisée en ce que le porte-buse de la tête de préhension (1) est monté sur l'arbre d'un moteur rotatif pas à pas (6) tournant autour d'un axe sensiblement vertical (ZZ') et destiné à régler l'orientation du composant, et la machine comporte, en plus du premier chariot (4) portant le support (5) de la tête de préhension (1) et mobile suivant l'axe sensiblement vertical (ZZ') un second chariot mobile suivant une première direction sensiblement horizontale (YY'), portant le premier chariot (4) et lui-même monté sur un troisième chariot mobile suivant une seconde direction horizontale (XX') sensiblement perpendiculaire à la première (YY'), et les mouvements de translation des chariots sont assurés par des moteurs pas à pas coopérant avec des courroies crantées assurant une transmission sans glissement.

11. Machine selon l'une quelconque des revendications précédentes, caractérisée en ce qu'elle comporte une table (7) destinée à porter au moins deux substrats et mobile en translation dans un plan sensiblement horizontal.

12. Machine selon l'une quelconque des revendications précédentes, caractérisée en ce qu'elle comporte des plateaux (33) portant des réglettes (56) de support de composants, les réglettes étant adaptées aux types et dimensions des composants qu'elles contiennent, et des vibreurs destinés à provoquer l'avance des composants sur les réglettes.

13. Machine selon l'une quelconque des revendications précédentes, caractérisée en ce qu'elle comporte un poste (27) de rangement de buses ayant plusieurs logements de buses, et des capteurs (32) en nombre au moins égal au nombre de logements et destinés à indiquer la présence ou l'absence d'une buse (17) à chacun des logements.

14. Machine selon l'une quelconque des revendications précédentes, caractérisée en ce qu'elle comporte un appareil de visée optique à réticule dont le déplacement est commandé à l'aide d'un levier de commande (38), la manipulation du levier permettant le positionnement du dispositif de visée et l'introduction de données correspondantes dans le dispositif de commande.

15. Machine selon la revendication 10, caractérisée en ce que le mini-ordinateur comporte un processeur maître et des processeurs esclaves, ces derniers étant destinés à commander les déplacements dans les différentes directions avec accélération et décélération des moteurs pas à pas.

**Claims**

1. Automatic machine for wiring hybrid electronic circuits by means of the transfer of components to substrates, incorporating a control device comprising a control desk, and at least one miniature wiring machine, the miniature wiring machine incorporating a miniature robot having a gripping head provided with a suction nozzle possessing a degree of freedom in rotation about its longitudinal axis, said wiring machine also incorporating a nozzle-monitoring device intended for checking the appropriate operating state of the suction nozzle, characterised in that the suction nozzle is interchangeable on the head, in that the gripping head is intended to be displaced according to three degrees of freedom in translation above several work-stations, such as a station for the loading and unloading of circuits to be wired, a component-recentring station, a fluxing station (11), a wiring station (8, 9) and a suction-nozzle storage station (27), and in that the said control device also possesses a mini-computer intended for controlling the various movements of the miniature robot and the nozzle-monitoring device.

2. Machine according to Claim 1, characterised in that the gripping head (1) is located on a support (5) mounted on a first carriage (4), in such a way that it can slide, at the same time normally being returned towards a specific first position, and the nozzle-monitoring device incorporates a first detector (22) intended for transmitting an indication as to whether the support (5) is in its specific first position or not.

3. Machine according to Claim 2, characterised in that the nozzle-monitoring device incorporates a second detector (24) intended for transmitting an indication that the first carriage (4) is in a specific second position.

4. Machine according to one of Claims 2 and 3, characterised in that at least one of the first and second detectors (22, 24) is formed by a microcontact or by an opto-electronic sensor.

5. Machine according to one of Claims 3 and 4, characterised in that the control device regulates the displacement of the gripping head (1), so that the nozzle comes in contact with the said second detector (24), forming an altitude reference, the first detector (22) giving an indication that the support has left its specific first position.

6. Machine according to Claim 5, characterised in that the control device determines the displacement of the carriage (4) between the specific second position indicated by the second detector (24) and the position which it occupies at the moment when the first detector (22) gives an indication that the support (5) has left its specific position.

7. Machine according to Claim 6, characterised in that the control device compares the displacement of the carriage (4) with a reference displacement and determines the divergence between the two displacements, and then, depending on whether this divergence is greater or less than a specific threshold, it indicates an anomaly or not.

8. Machine according to Claim 7, characterised in that the control device determines the direction of the divergence which has caused the indication of an anomaly, and indicates either that the nozzle is incorrectly mounted on the nozzle-holder, when the divergence is in a first direction, or that the nozzle is worn, when the divergence is in the opposite direction.

9. Machine according to any one of the preceding claims, characterised in that the nozzle-holder is connected to a suction device by means of a solenoid valve, and the nozzle-monitoring device incorporates a low-pressure manometric contact located in the suction circuit between the nozzle-holder and the solenoid valve and intended for detecting an air leak at the level of the nozzle (17) and thus indicating the presence or absence of a component at the end of the nozzle.

10. Machine according to any one of Claims 2 to 9, characterised in that the nozzle-holder of the gripping head (1) is mounted on the shaft of a rotary stepping motor (6) which rotates about a substantially vertical axis (Z, Z') and which is intended for adjusting the orientation of the component, and the machine possesses, in addition to the first carriage (4) carrying the support (5) of the gripping head (1) and movable along the substantially vertical axis (Z, Z'), a second carriage movable in a first substantially horizontal direction (Y, Y'), carrying the first carriage (4) and itself mounted on a third carriage movable in a second horizontal direction (X, X') substantially perpendicular to the first (Y, Y'), and the translational movements of the carriages are executed by means of stepping motors interacting with notched belts ensuring non-slip transmission.

11. Machine according to any one of the preceding claims, characterised in that it incorporates a table (7) intended for carrying at least two substrates and movable in translation in a substantially horizontal plane.

12. Machine according to any one of the preceding claims, characterised in that it incorporates plates (33) carrying component-supporting strips (56), the strips matching the types and dimensions of the components which they contain, and vibrators intended for causing the components to advance on the strips.

13. Machine according to any one of the preceding claims, characterised in that it incorporates a nozzle-storage station (27) having several nozzle receptacles, and sensors (32) at least equal in number to the number of receptacles and intended for indicating the presence or absence of a nozzle (17) at each of the receptacles.

14. Machine according to any one of the preceding claims, characterised in that it incorporates an optical sighting device with a reticle, the dis-placement of which is controlled by means of a control lever (38), the manipulation of the lever making it possible to position the sighting device and enter corresponding data in the control device.

15. Machine according to Claim 10, characterised in that the mini-computer incorporates a master processor and slave processors, the latter intended for controlling the displacements in the various directions, with acceleration and deceleration of the stepping motors.

**Patentansprüche**

1. Vorrichtung zur automatischen Herstellung elektronischer Hybridenschaltungen durch Aufbringen von Teilen auf einen Träger, mit einer ein Steuerpult aufweisenden Steuereinrichtung, mit wenigstens einer Miniatur-Verdrahtungsmaschine, die einen Miniaturroboter mit einem Greifkopf umfasst, welcher mit einer Ansaugdüse versehen ist, die einen Freiheitsgrad zur Drehung um ihre Längsachse hat, worin die genannte Verdrahtungsmaschine weiter eine Düsenüberwachungseinrichtung umfasst, die zur Funktionsüberprüfung der Ansaugdüse eingerichtet ist, dadurch gekennzeichnet, dass die Ansaugdüse an dem Greifkopf austauschbar angebracht ist, dass der Greifkopf in drei Translations-Freiheitsgraden über mehrere Arbeitspositionen verstellbar ist, die eine Aufnahmeposition und eine Abnahmeposition der zu verdrahtenden Schaltkreise, eine Ausrichtposition der Teile, eine Durchströmstation (11), eine Verdrahtungsstation (8, 9) und eine Abstellposition (27) der Ansaugdüse umfassen, und dass die Steuereinrichtung einen Kleinrechner aufweist, der dazu eingerichtet ist, die verschiedenen Bewegungen des Miniaturroboters und die Düsenüberwachungseinrichtung zu steuern.

2. Vorrichtung nach Anspruch 1, dadurch gekennzeichnet, dass der Greifkopf (1) auf einem Träger (5) angeordnet ist, der auf einem ersten Schlitten (4) dergestalt verschiebbar angebracht ist, dass er normalerweise auf eine erste vorbestimmte Position zurückgestellt wird, und dass die Düsenüberwachungseinrichtung einen ersten Detektor (22) aufweist, der zur Abgabe eines Signals in Abhängigkeit davon eingerichtet ist, ob der Träger (5) in seiner ersten vorbestimmten Position ist oder nicht.

3. Vorrichtung nach Anspruch 2, dadurch gekennzeichnet, dass die Düsenüberwachungseinrichtung einen zweiten Detektor (24) aufweist, der zur Abgabe eines Signals in Abhängigkeit davon eingerichtet ist, ob der erste Schlitten (4) in einer zweiten vorbestimmten Stellung ist.

4. Vorrichtung nach einem der Ansprüche 2 und 3, dadurch gekennzeichnet, dass wenigstens einer der ersten und zweiten Detektoren (22, 24) aus einem Mikroschalter oder einem opto-elektronischen Sensor besteht.

5. Vorrichtung nach einem der Ansprüche 3 und 4, dadurch gekennzeichnet, dass die Steuereinrichtung die Verschiebung des Greifkopfes (1) so steuert, dass die Düse mit dem zweiten Detektor (24) in Verbindung gelangt, der eine Bezugsgrösse der Höhe bildet und dass der erste Detektor (22) dabei ein Signal abgibt, welches beinhaltet, dass der Träger seine erste vorbestimmte Position verlässt.

6. Vorrichtung nach Anspruch 5, dadurch gekennzeichnet, dass die Steuereinrichtung die Verschiebung des Schlittens (4) zwischen der zweiten vorbestimmten Position, die durch den zweiten Detektor (24) gemeldet wird, und der Position steuert, die er in dem Augenblick einnimmt, in dem der erste Detektor (22) meldet, dass der Träger (5) seine vorbestimmte Position verlässt.

7. Vorrichtung nach Anspruch 6, dadurch gekennzeichnet, dass die Steuereinrichtung die Verschiebung des Schlittens (4) mit einer Bezugsgrösse der Verschiebung vergleicht und die Abweichung zwischen den beiden Verschiebungen bestimmt und je nachdem, ob diese Abweichung oberhalb oder unterhalb einer vorgegebenen Schwelle liegt, eine Unstimmigkeit anzeigt oder nicht.

8. Vorrichtung nach Anspruch 7, dadurch gekennzeichnet, dass die Steuereinrichtung die Richtung der Abweichung, welche die Meldung einer Unstimmigkeit hervorgerufen hat, bestimmt und anzeigt, dass die Düse entweder falsch an dem Düsenträger angebracht ist, wenn die Abweichung in einer ersten Richtung verläuft oder angibt, dass die Düse abgenutzt ist, wenn die Abweichung in entgegengesetzter Richtung vorliegt.

9. Vorrichtung nach einem der vorangehenden Ansprüche, dadurch gekennzeichnet, dass der Düsenträger über ein Magnetventil (Elektroschütz) mit einer Ansaugeinrichtung in Verbindung steht und dass die Düsenüberwachungseinrichtung einen Unterdruckkontakt aufweist, der in dem Ansaugweg zwischen dem Düsenträger und dem Magnetventil angeordnet und dazu eingerichtet ist, ein Luftleck in Höhe der Düse (17) zu erfassen und damit die Anwesenheit oder Abwesenheit eines Teils am Ende der Düse zu melden.

10. Vorrichtung nach einem der Ansprüche 2–9, dadurch gekennzeichnet, dass der Düsenträger des Greifkopfes (1) auf einer drehbaren Welle eines Schrittmotors (6) angebracht ist und sich um eine im wesentlichen vertikale Achse (ZZ') dreht, um damit die Ausrichtung des Teils zu steuern, dass die Vorrichtung zusätzlich zu dem ersten Schlitten (4) der den Träger (5) des Greifkopfes (1) trägt und der um die im wesentlichen vertikale Achse (ZZ') beweglich ist, einen zweiten Schlitten aufweist, der entlang einer ersten, im wesentlichen horizontalen Richtung (YY') beweglich ist, der den ersten Schlitten (4) trägt und der selbst an einem dritten beweglichen Schlitten angebracht ist, der in einer zweiten horizontalen Bewegungsrichtung (XX') beweglich ist, die im wesentlichen rechtwinklig zu der ersten horizontalen Richtung (YY') verläuft, und dass die Verschiebebewegungen der Schlitten durch Schrittmotoren sowie mittels dergestalt geschliffenen Zahnrädern, dass sie eine spielfreie Übertragung gewährleisten, erfolgen.

11. Vorrichtung nach einem der vorangehenden Ansprüche, dadurch gekennzeichnet, dass sie einen Tisch (7) aufweist, der zum Tragen wenigstens zweier Teile ausgebildet ist und in einer im wesentlichen horizontalen Ebene verschiebbar ist.

12. Vorrichtung nach einem der vorangehenden Ansprüche, dadurch gekennzeichnet, dass sie Platten (33) mit Linealen (56) aufweist, welche die Teile tragen, dass die Lineale an die Arten und Abmessungen der Teile, die sie tragen, angepasst sind und dass Rüttler dergestalt vorgesehen sind, dass sie einen Vorschub der Teile auf den Linealen hervorrufen.

13. Vorrichtung nach einem der vorangehenden Ansprüche, dadurch gekennzeichnet, dass sie eine Station (27) zum Abstellen der Düsen aufweist, welche mehrere Düsenablagen umfasst und dass eine wenigstens der Zahl der Ablagen entsprechende Anzahl Fühler (32) vorgesehen ist, welche dazu eingerichtet sind, das Vorhandensein oder Fehlen einer Düse (17) in jeder der Ablagen zu melden.

14. Vorrichtung nach einem der vorangehenden Ansprüche, dadurch gekennzeichnet, dass sie ein optisches Fadenkreuzgerät aufweist, dessen Verschiebung mittels eines Steuerhebels (38) steuerbar ist und dass durch Betätigung des Steuerhebels die Einstellung des Sichtgeräts und die Eingabe entsprechender Grössen in die Steuereinrichtung erfolgen.

15. Vorrichtung nach Anspruch 10, dadurch gekennzeichnet, dass der Kleinrechner einen Hauptprozessor und Hilfsprozessoren umfasst und dass die Hilfsprozessoren dazu eingerichtet sind, die Verschiebungen in den verschiedenen Richtungen durch Beschleunigen und Verzögern der Schrittmotore zu steuern.

FIG.1

0 036 826

FIG.2

FIG.3

23

4

5

FIG.4

23

12c  15  12b  14  12a  7

13

12

FIG.8

FIG.5

FIG.6

FIG.7

FIG.9

24

25

3

4

48

51

45

50

49

46

45

44

47

55

43 42

39

40 40

FIG.11

53 54

52

51

FIG.10

FIG.13

FIG.14

FIG.12